# EUROPEAN PATENT APPLICATION

(11) **EP 4 040 484 A1**
(43) Date of publication of application: **10.08.2022**
(21) Application number: 20871150.7
(22) Date of filing: 28.09.2020
(51) Int. Cl.: H01L 25/07, H01L 25/18, H01L 25/04, H01L 21/02, H01L 21/20, H01L 21/66, H01L 29/872, H01L 21/329

(54) **METHOD FOR MANUFACTURING SEMICONDUCTOR DEVICE AND SEMICONDUCTOR DEVICE**

(30) Priority: 30.09.2019 JP 2019178698
(71) Applicant: Kyocera Corporation, Kyoto-shi Kyoto 612-8501 (JP)
(72) Inventor: SAWADA, Tatsuro, Kyoto-shi, Kyoto 612-8501 (JP)
(74) Representative: Viering, Jentschura & Partner mbB Patent- und Rechtsanwälte
(86) International application number: PCT/JP2020/036662
(87) International publication number: WO 2021/065810

(57) **Abstract**

Provided is a method of manufacturing a semiconductor apparatus including a support substrate being common and plural semiconductor devices. The method includes: inspecting, regarding each of plural semiconductor devices 101 to 104 arranged on and supported by a support substrate 20 being common thereto, by measuring a predetermined electrical parameter, whether a measured value satisfies a predetermined condition; and forming an electrode by forming an electrode film 22 that is, among the plural semiconductor devices, electrically connected to a semiconductor device that has passed an inspection in the inspecting and electrically insulated from a semiconductor device that has failed the inspection in the inspecting so that the electrode film extends continuously over projected planes onto an arrangement surface 22A of the electrode film, that is, projected planes A1, A2, and A3 of semiconductor devices that have passed the inspection and a projected plane B1 of a semiconductor device that has failed the inspection, the semiconductor devices remaining supported by the common support substrate.

## Description

### Technical Field

The present disclosure relates to a method of manufacturing a semiconductor apparatus and a semiconductor apparatus.

### Background Art

There has been a technique called ELO (Epitaxial Lateral Overgrowth). With the technique, a layer of GaN (Galium Nitride) is grown by crystal growth in an opening of a growth mask provided on a substrate and is further laterally grown by crystal growth on the growth mask (Japanese Patent No. 4638958).

### Summary of Invention

According to an aspect of the present disclosure, there is provided a method of manufacturing a semiconductor apparatus including the support substrate being common and the plural semiconductor devices. The method includes: inspecting, regarding each of a plural semiconductor devices arranged on a support substrate being common thereto, by measuring a predetermined electrical parameter, whether a measured value satisfies a predetermined condition; and forming an electrode by forming an electrode film that is, among the plural semiconductor devices, electrically connected to a semiconductor device that has passed an inspection in the inspecting and electrically insulated from a semiconductor device that has failed the inspection in the inspecting so that the electrode film extends continuously over projected planes onto an arrangement surface of the electrode film, that is, a projected plane of the semiconductor device that has passed the inspection and a projected plane of the semiconductor device that has failed the inspection, the semiconductor devices remaining positioned on the common support substrate.

According to an aspect of the present disclosure, there is provided a semiconductor apparatus including: plural semiconductor devices arranged on a support substrate being common thereto; and an electrode film. The plural semiconductor devices include a first semiconductor device of which a predetermined electrical parameter satisfies a predetermined condition and a second semiconductor device of which the predetermined electrical parameter does not satisfy the predetermined condition. The electrode film is electrically connected to the first semiconductor device and electrically insulated from the second semiconductor device. The electrode film is positioned over projected planes onto an arrangement surface of the electrode film, that is, a projected plane of the first semiconductor device and a projected plane of the second semiconductor device.

### Brief Description of Drawings

[Fig. 1A] Fig. 1A is a schematic sectional view for illustrating an embodiment of the present disclosure.
[Fig. 1B] Fig. 1B is a schematic sectional view for illustrating the embodiment of the present disclosure.
[Fig. 1C] Fig. 1C is a schematic sectional view for illustrating the embodiment of the present disclosure.
[Fig. 1D] Fig. 1D is a schematic sectional view for illustrating the embodiment of the present disclosure.
[Fig. 2A] Fig. 2A is a schematic sectional view for illustrating the embodiment of the present disclosure.
[Fig. 2B] Fig. 2B is a schematic sectional view for illustrating the embodiment of the present disclosure.
[Fig. 2C] Fig. 2C is a schematic sectional view for illustrating the embodiment of the present disclosure.
[Fig. 2D] Fig. 2D is a schematic sectional view for illustrating the embodiment of the present disclosure.
[Fig. 2E] Fig. 2E is a schematic sectional view for illustrating the embodiment of the present disclosure.
[Fig. 3A] Fig. 3A is a schematic plan view for illustrating the embodiment of the present disclosure.
[Fig. 3B] Fig. 3B is a schematic plan view for illustrating the embodiment of the present disclosure.
[Fig. 3C] Fig. 3C is a schematic plan view for illustrating the embodiment of the present disclosure.
[Fig. 4] Fig. 4 is a schematic sectional view for illustrating the embodiment of the present disclosure.
[Fig. 5] Fig. 5 is a schematic sectional view for illustrating the embodiment of the present disclosure.
[Fig. 6A] Fig. 6A is a schematic sectional view for illustrating the embodiment of the present disclosure.
[Fig. 6B] Fig. 6B is a schematic sectional view for illustrating the embodiment of the present disclosure.
[Fig. 6C] Fig. 6C is a schematic sectional view for illustrating the embodiment of the present disclosure. Description of Embodiment

Hereinafter, an embodiment of the present disclosure will be described with reference to the drawings.

A semiconductor apparatus is manufactured as follows.

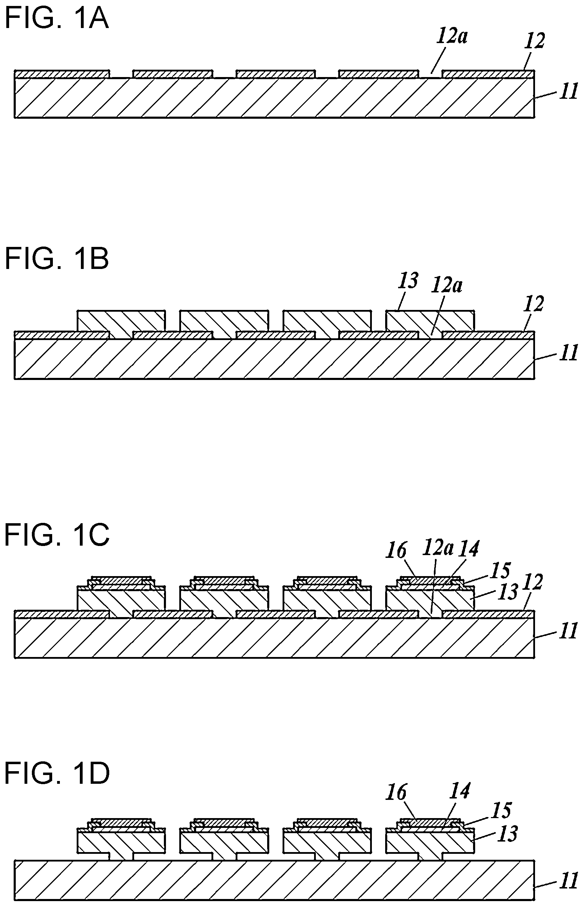

As Fig. 1A illustrates, a mask 12 of, for example, SiO2, SiN, AlN, Al2O3, or Ga2O3 is formed on the upper surface of a GaN layer that is a surface layer of a substrate 11. Note that the lower surface of the GaN layer that is the surface layer of the substrate 11 may be supported by, for example, a silicon substrate (not illustrated) other than GaN. For example, a sapphire substrate and a SiC (Silicon Carbide) substrate may also be possible. The mask 12 may be an amorphous mask.

The mask 12 has an opening 12a.

Subsequently, as Fig. 1B illustrates, by using the above-described ELO technique, GaN is epitaxially grown, from the surface of the substrate 11 exposed from the opening 12a, up to a position above an upper surface region of the vicinity of the exposed substrate 11 to form a GaN layer 13. The GaN layer 13 may be formed by plural layers having different impurity concentrations being layered on one another.

Subsequently, as Fig. 1C illustrates, a Schottky metal film 14 that forms a Schottky junction with the upper surface of the GaN layer 13 is formed. Note that, although an example of manufacturing a Schottky barrier diode as a semiconductor device is given here, the semiconductor device is not limited thereto.

Regarding the GaN layer 13, the doping amount of an n-type impurity is controlled so that the GaN layer 13 has an electron carrier concentration of less than 10¹⁷ cm⁻³. The n-type impurity may be, for example, Si (Silicon). Thus, it is possible to form a voltage resistance layer in which a depletion layer spreads when a voltage is applied during the operation of a device.

Subsequently, an insulating film 15 that covers a peripheral portion of the Schottky metal film 14 is formed.

Moreover, a device electrode 16 on the Schottky metal side is formed so as to be joined to the Schottky metal film 14 exposed from an opening of the insulating film 15.

Subsequently, as Fig. 1D illustrates, the mask 12 is removed by being broken apart by, for example, wet etching or dry etching.

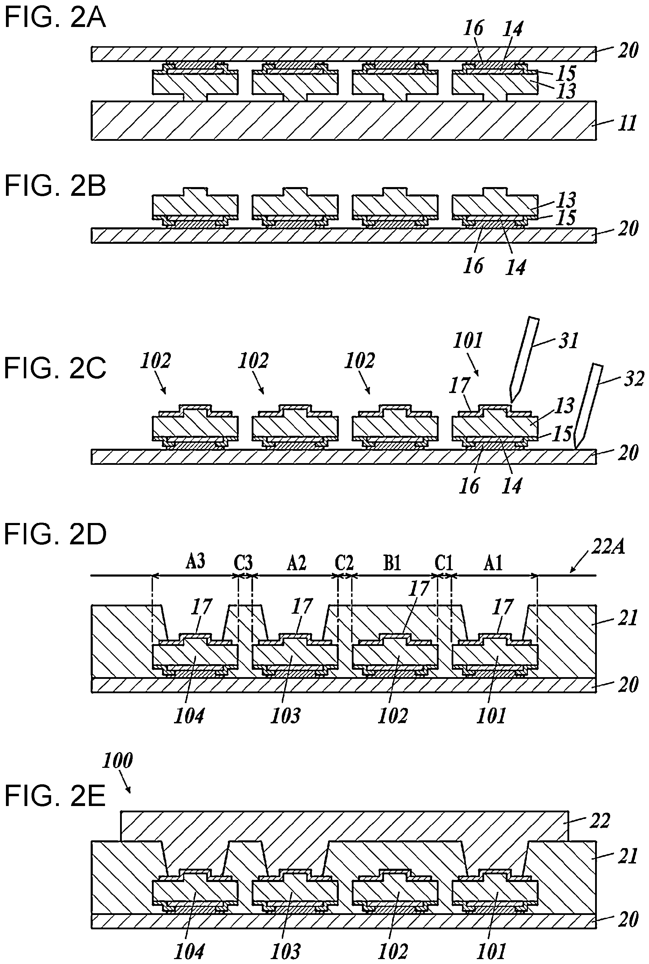

Subsequently, as Fig. 2A illustrates, to each of the device electrodes 16, a support substrate 20 being common to the device electrodes 16 is joined. Note that the support substrate 20 may be conductive. Such joining may be the joining with metal interposed therebetween or the direct joining to reduce connection resistance.

Note that the support substrate 20 may have a back-side electrode. The back-side electrode may be formed after a metal film 22 of an upper-side electrode, which will be described later, is formed. Alternatively, a support substrate 20 having a back-side electrode in advance may be used. The support substrate 20 may be a semiconductor having a high impurity concentration so as to have a low resistance.

Subsequently, as Fig. 2B illustrates, the semiconductor layer 13 is separated from the substrate 11 by a crystal being cracked by using, for example, ultrasound, and each device part is supported by the common support substrate 20. In Figs. 2B to 2E, the up/down orientation of Figs. 1A to 2A is reversed.

Subsequently, as Fig. 2C illustrates, device electrodes 17 that make ohmic contact with the respective semiconductor layers 13 are formed to form semiconductor devices 101 to 104. Here, as plural semiconductor devices, four semiconductor devices 101 to 104 are illustrated. However, it is assumed that, adjacent to the illustrated four semiconductor devices 101 to 104, a large number of similar semiconductor devices are further manufactured on the substrate 11 with a similar pitch.

As described above, there are obtained the plural semiconductor devices 101 to 104 including the semiconductor layers 13 produced by the ELO (Epitaxial Lateral Overgrowth) technique, in a state of being arranged on and supported by the common support substrate.

Next, an inspecting step for each of the plural semiconductor devices 101 to 104 is carried out.

That is, regarding each of the plural semiconductor devices 101 to 104, a predetermined electrical parameter is measured by using inspection pieces 31 and 32 or other tools, and whether the measured value satisfies a predetermined condition is inspected.

Regarding such a predetermined electrical parameter, the number and types thereof are not particularly limited.

The electrical parameter may include forward voltage, and the predetermined condition may include a condition where a value of the forward voltage is within a predetermined range.

The electrical parameter may include breakdown voltage, and the predetermined condition may include a condition where a value of the breakdown voltage is within a predetermined range.

The electrical parameter may include the amount of leakage current, and the predetermined condition may include a condition where a value of the amount of the leakage current when a predetermined reverse voltage is applied is within a predetermined range.

The electrical parameter may include electric capacity, and the predetermined condition may include a condition where a value of the electric capacity is within a predetermined range.

In addition thereto, various electrical parameters can be adopted.

Here, it is assumed that the first semiconductor device 101 has passed the inspection, the second semiconductor device 102 has failed the inspection, the third semiconductor device 103 has passed the inspection, and the fourth semiconductor device 104 has passed the inspection.

Subsequently, after a passivation film 21 that covers the plural semiconductor devices 101 to 104 is formed, as Fig. 2D illustrates, the device electrodes 17 of the semiconductor devices 101, 103, and 104 that have passed the inspection are exposed by openings being formed in portions of the passivation film 21 that correspond to the semiconductor devices 101, 103, and 104. In the vicinity of the semiconductor device 102, no opening is formed in the passivation film 21, and the device electrode 17 of the semiconductor device 102 is not exposed.

Subsequently, as Fig. 2E illustrates, the electrode film 22 that covers the passivation film 21 and the device electrodes 17 exposed from the openings of the passivation film 21 is formed (an electrode forming step) to form a semiconductor apparatus 100. Because being covered with the passivation film 21, the device electrode 17 of the semiconductor device 102 is insulated from the electrode film 22.

Thus, the electrode film 22 is, among the plural semiconductor devices 101 to 104, electrically connected to the semiconductor devices 101, 103, and 104 that have passed the inspection in the inspecting step and electrically insulated from the semiconductor device 102 that has failed the inspection in the inspecting step, and the electrode film 22 is included in the semiconductor apparatus 100.

The semiconductor apparatus 100 includes the plural semiconductor devices 101 to 104 arranged on and supported by the common support substrate 20 and includes the electrode film 22.

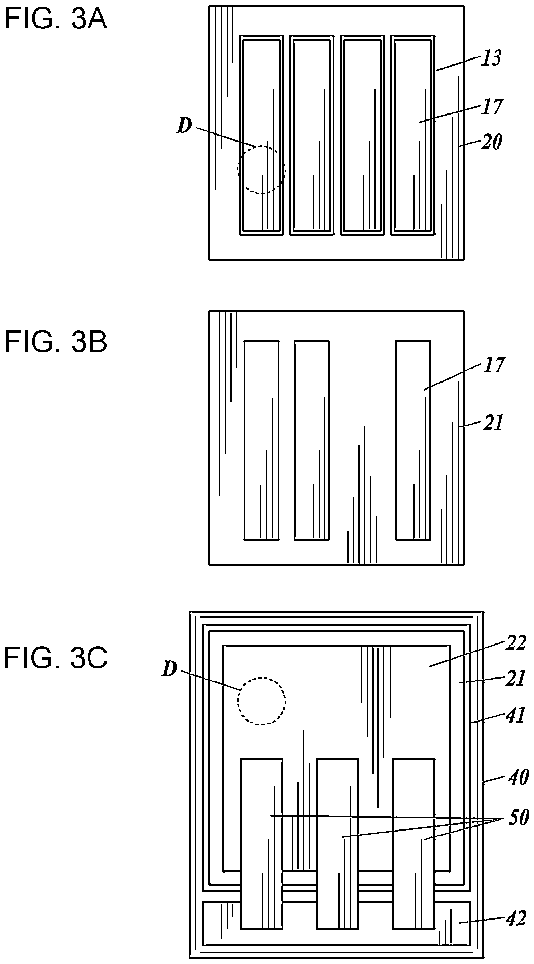

A plan view corresponding to Fig. 2C is illustrated in Fig. 3A. A plan view corresponding to Fig. 2D is illustrated in Fig. 3B. A plan view corresponding to Fig. 2E is illustrated in Fig. 3C. However, a mounting board 40 and a bonding wire 50 are further illustrated in Fig. 3C.

After the substrate is cut by dicing on a unit basis, the unit being constituted by the semiconductor devices (101 to 104) that are grouped together to be incorporated into one semiconductor apparatus, as Fig. 3C illustrates, the support substrate 20, which is the back side of the semiconductor apparatus 100, is die-bonded to an electrode pad 41 on the mounting board 40, and the electrode film 22, which is the upper side, and an electrode pad 42 on the mounting board 40 are connected to one another by the bonding wires 50.

In the above-described electrode forming step, the electrode film 22 is formed so as to extend continuously over projected planes onto an electrode-film arrangement surface 22A illustrated in Fig. 2D, that is, projected planes A1, A2, A3 of the semiconductor devices that have passed the inspection and remain supported by the common support substrate 20 and a projected plane B1 of the semiconductor device that has failed the inspection and remains supported by the common support substrate 20. Note that such projection is orthogonal projection onto the electrode-film arrangement surface 22A.

As a result, the area of the electrode film 22 exceeds the area of one projected plane A1 (A2, A3) of one semiconductor device that has passed the inspection.

On the common support substrate 20, there are further provided inter-device regions between the plural semiconductor devices 101 to 104. In the above-described electrode forming step, the electrode film 22 is also positioned at projected planes C1 and C2 of the inter-device regions between the semiconductor devices that have passed the inspection and the semiconductor device that has failed the inspection.

As a result, the area of the electrode film 22 exceeds the area of the projected planes A1, A2, A3, and B1 of the plural semiconductor devices.

Moreover, because there are plural semiconductor devices that have passed the inspection, the electrode film 22 is formed so as to extend continuously over the projected planes A1, A2, and A3 of the plural semiconductor devices that have passed the inspection.

In the present embodiment, the electrode film 22 is formed, while having a large area, over the projected planes A1, A2, A3, B1, C1, C2, and C3.

As described above, it is possible to manufacture the large capacity semiconductor apparatus 100 without rearranging the devices since a layer forming process that is carried out on the substrate 11, and it is possible for the semiconductor apparatus 100 to be provided with the electrode film 22 having a large area and being easily subjected to wire-bonding.

Such unnecessity of rearranging devices enables excellent manufacturability.

It is possible to obtain a compact, high-density mounting semiconductor apparatus having a small arrangement pitch of the devices that follows the forming pitch of the devices provided in the process carried out on the substrate 11.

As Fig. 3A illustrates, the projected plane (upper surface) of each of the semiconductor devices that have passed the inspection does not have a region in which a circle D having a diameter of a predetermined length can be accommodated.

In contrast, as Fig. 3C illustrates, the upper surface of the electrode film 22 has a region in which the circle D can be accommodated.

In a wire-bonding step, the wire 50 that is made thick so as to have a diameter larger than or equal to the predetermined length is bonded to a region of the upper surface of the electrode film 22 in which the circle D can be accommodated.

Thus, it is easy to bond a wire having a thickness larger than or equal to the width of one device. Accordingly, it is possible to obtain effects of, for example, reducing wiring resistance and improving bonding reliability due to a wire having a large thickness. In addition, an apparatus capable of bonding a thin wire is not necessarily specifically prepared, and it is thereby possible to prevent the cost of equipment from increasing.

In addition, the number of wires can be reduced by a wire being made thick, and it is thereby possible to obtain an effect of, for example, reducing the time for the step.

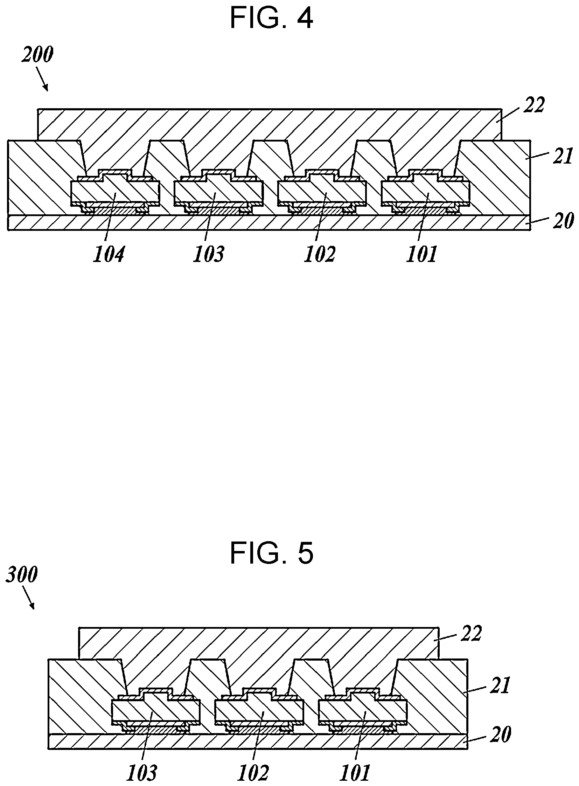

Note that, even when all the plural semiconductor devices 101 to 104 have passed the inspection in the inspecting step, as Fig. 4 illustrates, the electrode film 22 is formed so as to extend continuously over the projected planes onto the electrode-film arrangement surface, that is, the projected planes of the plural semiconductor devices.

As Fig. 4 illustrates, when a semiconductor apparatus 200 including four operable semiconductor devices 101 to 104 is manufactured, the semiconductor apparatus 200 may be provided for a user as a different type of product having a different capacity size, while being distinguished from the semiconductor apparatus 100, in Fig. 2E, including three operable semiconductor devices.

In addition, according to the number of the semiconductor devices that have failed the inspection, the number of the semiconductor devices to be included in the semiconductor apparatus may be increased to keep, constant, the number of the semiconductor devices that have passed the inspection.

For example, the following describes the case of keeping the number of the devices three. When the first semiconductor device 101 has passed the inspection, the second semiconductor device 102 has passed the inspection, and the third semiconductor device 103 has passed the inspection, as Fig. 5 illustrates, the number of the semiconductor devices to be included in a semiconductor apparatus 300 is three, and the semiconductor devices 101 to 103 are included in the semiconductor apparatus 300 and are all connected to the electrode film 22.

On the other hand, when the first semiconductor device 101 has passed the inspection, the second semiconductor device 102 has failed the inspection, and the third semiconductor device 103 has passed the inspection and if the fourth semiconductor device 104 has passed the inspection, the fourth semiconductor device 104 is included in the semiconductor apparatus and is connected to the electrode film 22. This configuration may correspond to the semiconductor apparatus 100 illustrated in Fig. 2E.

After this, the number of the semiconductor devices to be included in the semiconductor apparatus is increased until the number of the inspection-passing devices reaches a target number, and the number of the inspection-passing semiconductor devices that are included in the semiconductor apparatus and externally connected is kept constant. However, in consideration of the size of the semiconductor apparatus, when the total number exceeds a predetermined value, the grouping in Fig. 2E, starting from the first semiconductor device 101 may be cancelled. The grouping may be shifted to a grouping starting from the semiconductor device (103) that is a next product that has passed the inspection to perform processing.

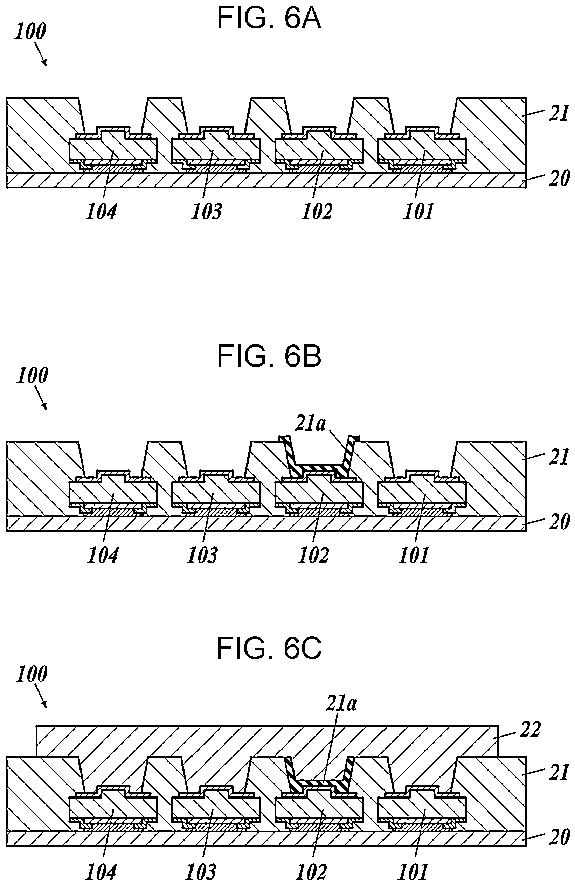

Note that, as Fig. 6A, Fig. 6B, and Fig. 6C illustrate, processing can be performed in a similar way even when, after forming openings in all the portions of the passivation film 21 positioned above the respective devices, only the semiconductor device that has failed the inspection is covered with an insulating film 21a.

Although the embodiment of the present disclosure has so far been described, the embodiment is described as an example. The present disclosure can be carried out in various other forms, and the constituents may be omitted, replaced, or modified without departing from the scope of the present disclosure.

The parallelization of plural semiconductor devices is optionally carried out. In the above embodiment, the case where there are plural semiconductor devices that have passed the inspection, and the plural semiconductor devices are connected in parallel to one another is described. However, there may be provided one semiconductor device that is included in one semiconductor apparatus, has an electrical parameter satisfying a predetermined condition, and is connected to the electrode film 22. The electrode film 22 larger than the upper surface of the one semiconductor device can be formed.

In addition, the predetermined condition that the electrical parameter is to satisfy is not necessarily a condition according to a predetermined constant and may be a relative condition. For example, among the plural semiconductor devices arranged on the support substrate 20, semiconductor devices whose measured values of the electrical parameter are closer to an ideal value are selected in descending order from the highest-ranked semiconductor device, and a lower-ranked semiconductor device may be treated as an inspection failure, that is, may be insulated from the electrode film 22. For example, when four semiconductor devices are collected in one group, the three top-ranked semiconductor devices are connected to the electrode film 22, and one lower-ranked semiconductor device, while being insulated from the electrode film 22, is incorporated into the semiconductor apparatus. Alternatively, for example, when two semiconductor devices are collected in one group, between the two semiconductor devices, one higher-ranked semiconductor device is connected to the electrode film 22, one lower-ranked semiconductor device is insulated from the electrode film 22, and the two semiconductor devices are incorporated into the semiconductor apparatus. Thus, it is possible to improve yields and performance.

In the above embodiment, the substrate 11 provided in the forming process of the semiconductor layer is not incorporated into the semiconductor apparatus, and it is thereby possible to reuse the substrate 11. However, it is unnecessary to stick to such an idea, and the substrate 11 may be incorporated into the semiconductor apparatus as a common support substrate.

In addition, although the device parts are transferred from the substrate 11 onto the above-described support substrate 20 while the arrangement of the device parts being kept, there may be provided a support substrate onto which the device parts further transferred from the support substrate 20 in a similar way, and the support substrate may be incorporated into the semiconductor apparatus as a common support substrate. Regarding such transfer of the device parts with the arrangement thereof being kept, there is no limit in the number of times the transfer is performed.

### Industrial Applicability

The present disclosure is applicable to a method of manufacturing a semiconductor apparatus and a semiconductor apparatus.

### Reference Signs List

- 11: substrate
- 12: mask
- 12a: opening
- 13: GaN layer (semiconductor layer)
- 14: Schottky metal film
- 15: insulating film
- 16: device electrode
- 17: device electrode
- 20: support substrate
- 21: passivation film
- 21a: insulating film
- 22: electrode film
- 22A: electrode-film arrangement surface
- 31 and 32: inspection piece
- 40: mounting board
- 41: electrode pad
- 42: electrode pad
- 50: bonding wire
- 100: semiconductor apparatus
- 101 to 104: semiconductor device
- 200: semiconductor apparatus
- 300: semiconductor apparatus
- A1, A2, A3, B1, C1, C2, and C3: projected plane
- D: circle

## Claims

1. A method of manufacturing a semiconductor apparatus comprising the support substrate being common and the plurality of semiconductor devices, the method comprising:
inspecting, regarding each of a plurality of semiconductor devices arranged on a support substrate being common thereto, by measuring a predetermined electrical parameter, whether a measured value satisfies a predetermined condition; and
forming an electrode by forming an electrode film that is, among the plurality of semiconductor devices, electrically connected to a semiconductor device that has passed an inspection in the inspecting and electrically insulated from a semiconductor device that has failed the inspection in the inspecting so that the electrode film extends continuously over projected planes onto an arrangement surface of the electrode film, that is, a projected plane of the semiconductor device that has passed the inspection and a projected plane of the semiconductor device that has failed the inspection, the semiconductor devices remaining positioned on the common support substrate.

2. The method of manufacturing the semiconductor apparatus, according to Claim 1,
wherein the semiconductor apparatus has, on the common support substrate, an inter-device region between the plurality of semiconductor devices, and
wherein, in the forming the electrode, the electrode film is also positioned at a projected plane of an inter-device region between the semiconductor device that has passed the inspection and the semiconductor device that has failed the inspection.

3. The method of manufacturing the semiconductor apparatus, according to Claim 1 or Claim 2,
wherein an area of the electrode film exceeds an area of a projected plane of the semiconductor device that has passed the inspection.

4. The method of manufacturing the semiconductor apparatus, according to Claim 1 or Claim 2,
wherein an area of the electrode film exceeds an area of projected planes of the plurality of semiconductor devices.

5. The method of manufacturing the semiconductor apparatus, according to any one of Claims 1 to 4,
wherein the electrical parameter includes forward voltage, and
wherein the predetermined condition includes a condition where a value of the forward voltage is within a predetermined range.

6. The method of manufacturing the semiconductor apparatus, according to any one of Claims 1 to 5,
wherein the electrical parameter includes breakdown voltage, and
wherein the predetermined condition includes a condition where a value of the breakdown voltage is within a predetermined range.

7. The method of manufacturing the semiconductor apparatus, according to any one of Claims 1 to 6,
wherein the electrical parameter includes an amount of leakage current, and
wherein the predetermined condition includes a condition where a value of the amount of the leakage current when a predetermined reverse voltage is applied is within a predetermined range.

8. The method of manufacturing the semiconductor apparatus, according to any one of Claims 1 to 7,
wherein the electrical parameter includes electric capacity, and
wherein the predetermined condition includes a condition where a value of the electric capacity is within a predetermined range.

9. The method of manufacturing the semiconductor apparatus, according to any one of Claims 1 to 8,
wherein a projected plane of the semiconductor device that has passed the inspection does not have a region in which a circle having a diameter of a predetermined length is capable of being accommodated,
wherein an upper surface of the electrode film has a region in which the circle is capable of being accommodated, and
wherein a wire being made thick so as to have a diameter larger than or equal to the predetermined length is bonded to, in the upper surface, a region in which the circle is capable of being accommodated.

10. The method of manufacturing the semiconductor apparatus, according to any one of Claims 1 to 9,
wherein, when there are a plurality of the semiconductor devices that have passed the inspection, the electrode film is formed so as to extend continuously over projected planes onto the arrangement surface of the electrode film, that is, projected planes of the plurality of semiconductor devices that have passed the inspection.

11. The method of manufacturing the semiconductor apparatus, according to any one of Claims 1 to 10,
wherein, when all the plurality of semiconductor devices are semiconductor devices that have passed the inspection in the inspecting, the electrode film is formed so as to extend continuously over projected planes onto the arrangement surface of the electrode film, that is, projected planes of the plurality of semiconductor devices.

12. The method of manufacturing the semiconductor apparatus, according to any one of Claims 1 to 11, further comprising:
disposing a mask having a plurality of openings, on a surface of a substrate; and
epitaxially growing a semiconductor layer from the surface of the substrate exposed from the openings to produce the plurality of semiconductor devices.

13. The method of manufacturing the semiconductor apparatus, according to Claim 12,
wherein, in the epitaxially growing, the semiconductor is grown up to a position above the mask.

14. The method of manufacturing the semiconductor apparatus, according to Claim 12 or Claim 13,
wherein the substrate serves as the support substrate.

15. The method of manufacturing the semiconductor apparatus, according to Claim 12 or Claim 13,
wherein the mask is removed,
with a surface of the semiconductor layer on an opposite side with respect to the substrate being joined to a support substrate, the semiconductor layer is separated from the substrate and transferred onto the support substrate, and
the support substrate or a support substrate onto which the semiconductor layer is further transferred from the support substrate in a similar way serves as the common support substrate.

16. The method of manufacturing the semiconductor apparatus, according to any one of Claims 1 to 15,
wherein the plurality of semiconductor devices include a GaN semiconductor.

17. The method of manufacturing the semiconductor apparatus, according to any one of Claims 1 to 16,
wherein, according to a number of the semiconductor devices that have failed the inspection, a number of semiconductor devices to be included in the semiconductor apparatus is increased or decreased to keep, constant, a number of the semiconductor devices that have passed the inspection.

18. A semiconductor apparatus comprising:
a plurality of semiconductor devices arranged on a support substrate being common thereto; and
an electrode film,
wherein the plurality of semiconductor devices include a first semiconductor device of which a predetermined electrical parameter satisfies a predetermined condition and a second semiconductor device of which the predetermined electrical parameter does not satisfy the predetermined condition, and
wherein the electrode film is electrically connected to the first semiconductor device and electrically insulated from the second semiconductor device,
the electrode film being positioned over projected planes onto an arrangement surface of the electrode film, that is, a projected plane of the first semiconductor device and a projected plane of the second semiconductor device.

19. The semiconductor apparatus according to Claim 18,
wherein, on the common support substrate, there is an inter-device region between the plurality of semiconductor devices, and
wherein the electrode film is also positioned at a projected plane of an inter-device region between the first semiconductor device and the second semiconductor device.

20. The semiconductor apparatus according to Claim 18 or Claim 19,
wherein an area of the electrode film exceeds an area of a projected plane of the first semiconductor device.

21. The semiconductor apparatus according to Claim 18 or Claim 19,
wherein an area of the electrode film exceeds an area of projected planes of the plurality of semiconductor devices.

22. The semiconductor apparatus according to any one of Claims 18 to 21,
wherein the electrical parameter includes forward voltage, and
wherein the predetermined condition includes a condition where a value of the forward voltage is within a predetermined range.

23. The semiconductor apparatus according to any one of Claims 18 to 22,
wherein the electrical parameter includes breakdown voltage, and
wherein the predetermined condition includes a condition where a value of the breakdown voltage is within a predetermined range.

24. The semiconductor apparatus according to any one of Claims 18 to 23,
wherein the electrical parameter includes an amount of leakage current, and
wherein the predetermined condition includes a condition where a value of the amount of the leakage current when a predetermined reverse voltage is applied is within a predetermined range.

25. The semiconductor apparatus according to any one of Claims 18 to 24,
wherein the electrical parameter includes electric capacity, and
wherein the predetermined condition includes a condition where a value of the electric capacity is within a predetermined range.

26. The semiconductor apparatus according to any one of Claims 18 to 25,
wherein a projected plane of the first semiconductor device does not have a region in which a circle having a diameter of a predetermined length is capable of being accommodated,
wherein an upper surface of the electrode film has a region in which the circle is capable of being accommodated, and
wherein a wire being made thick so as to have a diameter larger than or equal to the predetermined length is bonded to, in the upper surface, a region in which the circle is capable of being accommodated.

27. The semiconductor apparatus according to any one of Claims 18 to 26,
wherein the plurality of semiconductor devices include a third semiconductor device of which a predetermined electrical parameter satisfies a predetermined condition, and
wherein the electrode film is positioned over projected planes onto the arrangement surface of the electrode film, that is, a projected plane of the first semiconductor device and a projected plane of the third semiconductor device.

28. The semiconductor apparatus according to any one of Claims 18 to 27,
wherein the plurality of semiconductor devices include a semiconductor layer produced by an Epitaxial Lateral Overgrowth technique.

29. The semiconductor apparatus according to any one of Claims 18 to 28,
wherein the plurality of semiconductor devices include a GaN semiconductor.
